# EUROPEAN PATENT APPLICATION

(11) **EP 1 607 981 A1**
(43) Date of publication of application: **21.12.2005**
(21) Application number: 05012604.4
(22) Date of filing: 11.06.2005
(51) Int. Cl.: G11C 11/34

(54) **Phase-change memory device and write driver circuit and programming method**

(30) Priority: 19.06.2004 KR 2004045849; 29.03.2005 US 92456
(71) Applicant: Samsung Electronics Co., Ltd., Suwon-si, Gyeonggi-Do (KR)
(72) Inventor: Cho, Woo-yeong, Taean-eub Hwaseong-si Gyeonggi-do (KR); Kang, Sang-beom, Taean-eub Hwaseong-si Gyeonggi-do (KR)
(74) Representative: Weller, Erich W.

(57) **Abstract**

A phase-change memory device, a corresponding write driver circuit, and a corresponding programming method are provided capable of controlling an amount of current supplied to a phase-change material of the phase-change memory device based on a measure of resistance of the phase-change material during programming of the phase-change memory device. Such control may be based on detected voltage or current. The amount of current supplied to the phase-change material may be increased until the measured voltage level changes with respect to a reference voltage value and the current maintained constant if the measured voltage level has changed with respect to the reference voltage value. The change of the measured voltage level with respect to the reference voltage may be the measured voltage level falling below the reference voltage value.

## Description

The invention relates to a phase-change memory device, a corresponding write driver circuit and a corresponding programming method. The application is related to and claims priority from Korean Patent Application No. 10-2004-0045849, filed on June 19, 2004, in the Korean Intellectual Property Office, the disclosure of which is incorporated by reference herein in its entirety.

A phase-change memory element is a memory element for storing information using the characteristics of electric conductivity or a resistance difference between a crystalline phase and an amorphous phase of a specific phase-change material. The phase-change memory element forms a memory cell electrically connected to a transistor element or the like, formed on a semiconductor substrate for addressing and read/write operations of the device. In the memory element, information is stored using a conductivity difference in accordance with the phase-change of a memory layer, and data is stored in the phase-change memory element including a phase-change region.

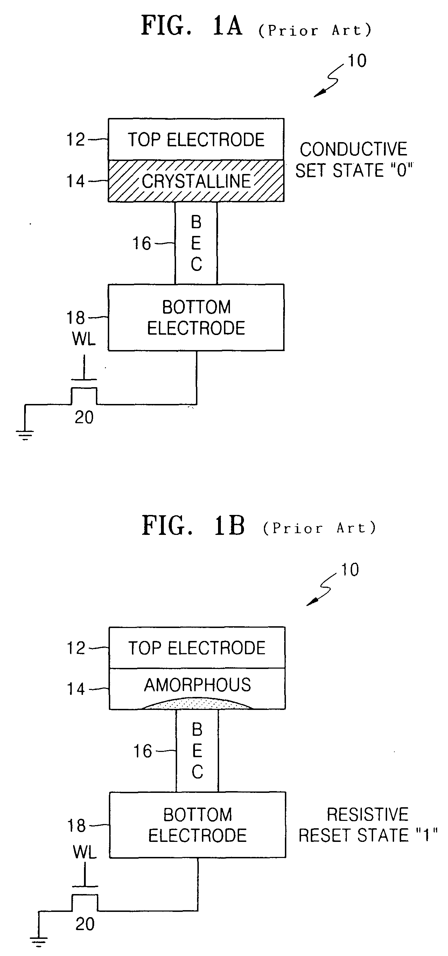

**FIG. 1A** and **FIG 1B** illustrate a conventional phase-change memory cell **10.** As seen in **FIG. 1A,** the phase-change memory cell includes a phase-change material **14** between a top electrode **12** and a bottom electrode **18.** To increase the current density and, thereby, improve the efficiency of heating of the phase-change material **14,** the bottom electrode **18** may be connected to the phase-change material **14** through a bottom electrode contact (BEC) **16** that has reduced surface area in comparison to the bottom electrode **18.** An access transistor **20** may be connected to the bottom electrode **18** and controlled by a word line (WL).

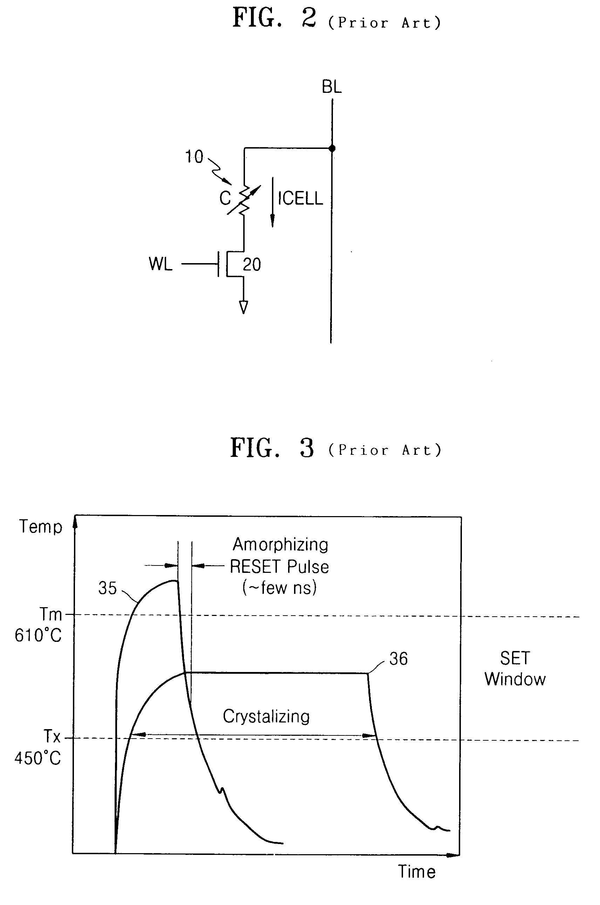

As seen in **FIGs. 1A, 1B** and **2,** the phase-change memory cell **10** operates such that a current flowing through the phase-change material **14** electrically heats a phase-change region, and the structure of the phase-change material **14** is reversibly changed to a crystalline state (**FIG. 1A**) or an amorphous state (**FIG. 1B**) to store information. The stored information can be read by flowing a relatively low current through the phase-change region and measuring the resistance of the phase-change material.

In setting the phase-change material layer **14** to an amorphous state or a crystalline state, different pulses may be used to control the heating of the phase-change material layer. As seen in **FIG. 3,** a high temperature short duration heating cycle **35** is used to reset the phase-change material **14** to an amorphous state and a longer duration lower temperature heating cycle **36** is used to set the phase-change material **14** to a crystalline state. In particular, in the short duration cycle **35,** the phase-change material **14** is heated to a temperature above the melting point, Tm, of the phase-change material and then quickly cooled, *e*.*g*., within a few nanoseconds, to create an amorphous region in the phase-change material **14.** In the longer duration cycle **36,** the phase-change material **14** is heated to a temperature above a crystallizing point, Tx, and below the melting point, Tm, of the phase-change material and maintained at that temperature for a predetermined time before cooling to create a crystallized region in the phase-change material **14.** Thus, the temperature is maintained within a set window of above the crystallizing temperature Tx and below the melting temperature Tm.

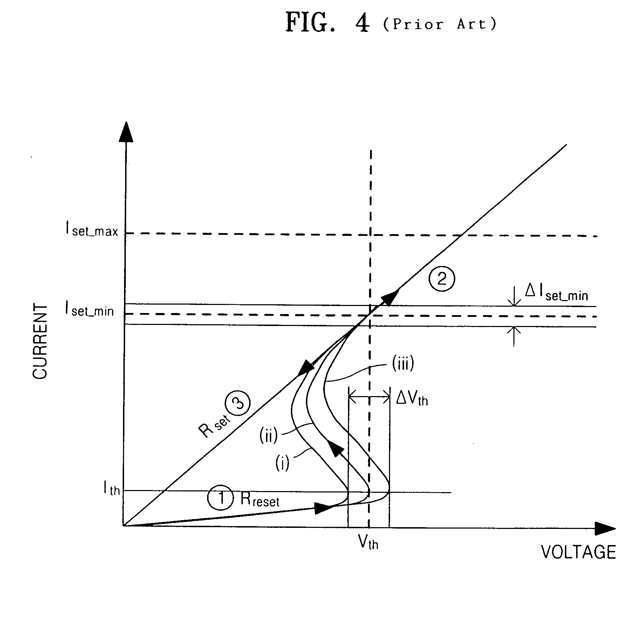

**FIG. 4** is a graph of the voltage-current relationship for a typical phase-change material **14.** As seen in **FIG. 4,** the graph is divided into a reset state, 1, and a set state, 3, for a read operation and a section, 2, for programming the state of the phase-change material **14.** Thus, in reading the phase-change material, states 1 or 3, the current to voltage relationship is linear based on the resistance of the phase-change material. However, the programming section, 2, is non-linear. Accordingly, to program the phase-change material **14** the voltage is increased to above the threshold voltage and the current increases to the minimum programming current non-linearly.

In an array of memory cells, the different memory cells may have different threshold voltages and, accordingly, different minimum set currents. Thus, as seen in **FIG. 4,** for different cells, reflected in the lines labeled i, ii and iii, the threshold voltage and the minimum set current may vary. However, conventionally, all the memory cells are typically programmed with substantially the same current.

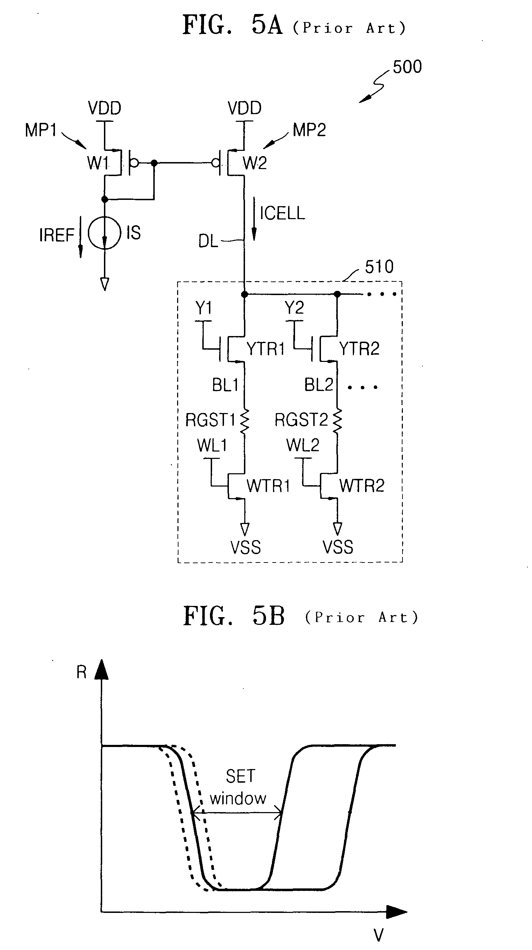

Furthermore, as seen in **FIGs. 5A** and **5B**, a conventional phase-change memory device **500** may have difficulty controlling the voltage applied to the memory cells to assure that all of the memory cells exceed the threshold voltage. As seen in FIG. **5A,** a current mirror controls the current supplied to program the memory cells **510** such that the cell current ICELL is controlled by the reference current IREF. During programming from the reset state to the set state, if a voltage lower than the threshold voltage Vth of the phase-change material **14** is supplied to the phase-change material **14,** the voltage level of the data line DL is close to the level of the power supply voltage VDD. If the amount of set current ICELL supplied to the PCM is increased by increasing the reference current IREF, a level of the voltage supplied to the PCM may be increased beyond the threshold voltage Vth. Thus, the resistance of the phase-change material changes to the dynamic resistance and the voltage level of the data line DL becomes lower than the level of the power supply voltage VDD. Such a change in voltage may be problematic where the different memory cells have different threshold voltages and may cause some cells to not be set if the same current is applied to all the cells as the voltage may not reach the threshold voltage, reduction of reset current may also cause difficulty in fitting the set current into the narrowed set window and it may be difficult to maintain the voltage and/or current in the set window as illustrated in **FIG. 5B** for all of the devices.

It is the technical problem underlying the invention to provide for a phase change memory device, a phase change memory write driver circuit, and a method of programming a phase-change memory device, which are capable to at least partially overcome the above-mentioned difficulties of the prior art and in particular to accomplish that all memory cells of an array are reliably programmed in a programming operation even if they have different threshold voltages.

The invention solves this problem by providing a method of programming a phase change memory device having the features of claim 1, a phase change memory device having the features of claim 11, and a phase change memory write drive circuit having the features of claim 23.

Advantageous embodiments of the invention are mentioned in the subclaims, the wording of which is incorporated herewith into the description by reference to avoid unnecessary text repetition.

In corresponding embodiments the invention provides for programming a phase-change memory device by controlling an amount of current supplied to a phase-change material of the phase-change memory device based on a measure of resistance of the phase-change material during programming of the phase-change memory device.

In particular embodiments of the invention, controlling an amount of current includes measuring a voltage across the phase-change material of the phase-change memory device and controlling an amount of current supplied to the phase-change material of the phase-change memory device based on the measured voltage across the phase-change material. Furthermore, controlling an amount of current supplied may include increasing the amount of current supplied to the phase-change material until the measured voltage level changes with respect to a reference voltage value and maintaining the current constant if the measured voltage level has changed with respect to the reference voltage value. The change of the measured voltage level with respect to the reference voltage may be the measured voltage level falling below the reference voltage value.

In still further embodiments of the invention, increasing the amount of current supplied to the phase-change material until the measured voltage level changes with respect to a reference voltage value includes increasing the amount of a reference current supplied to a current mirror circuit so as to increase an amount of current supplied to the phase-change material until the measured voltage level changes with respect to a reference voltage value controlling an amount of current supplied. A node of the current mirror that controls the current supplied to the phase-change material may be precharged and, in some embodiments, precharged responsive to a power on signal. In further embodiments, a node where the voltage across the phase-change material is detected is precharged. For example, the node that is precharged may be a data line of the phase-change memory device.

In still further embodiments of the invention where current supplied to the phase-change material is supplied by a current mirror circuit, maintaining the current constant includes floating a node of the current mirror that controls the current supplied to the phase-change material when voltage falls below reference voltage.

In additional embodiments of the invention, controlling an amount of current includes measuring a current supplied to the phase-change material of the phase-change memory device and controlling an amount of current supplied to the phase-change material of the phase-change memory device based on the measured current supplied to the phase-change material. Furthermore, controlling an amount of current supplied may include increasing the amount of current supplied to the phase-change material until the measured current changes with respect to a reference current value and maintaining the current constant if the measured current has changed with respect to the reference current value. The change of the measured current with respect to the reference voltage may be the measured current exceeding the reference current value.

Some embodiments of the invention provide phase-change memory devices, that includes a phase-change memory cell comprising a phase-change material, a detection circuit configured to measure a voltage and/or current of a data line coupled to the phase-change memory cell and a controller circuit coupled to the phase-change memory cell and configured to control an amount of current supplied to the phase-change material of the phase-change memory cell based on an output of the detection circuit.

In particular embodiments of the invention, the detection circuit comprises a voltage detection circuit. The voltage detection circuit may be configured to compare the measured voltage of the data line and a reference voltage and output a control signal based on whether the measured voltage is greater than or less than the reference voltage. The controller circuit may include a current mirror circuit configured to increase an amount of current supplied to the phase-change memory cell until the control signal output by the voltage detection circuit indicates that the measured voltage is less than the reference voltage and maintain the amount of current supplied to the phase-change memory cell when the control signal output by the voltage detection circuit indicates that the measured voltage is less than the reference voltage.

In still further embodiments of the invention, the current mirror circuit is further responsive to a first control signal to control whether or not current is supplied to the phase-change memory cell. The current mirror circuit may include a first transistor having controlled terminals coupled between a data line of the phase-change memory cell and a supply voltage, a charge storage element coupled between a controlling terminal of the first transistor and the supply voltage, a second transistor responsive to the first control signal that selectively couples the controlling terminal of the first transistor to the supply voltage and a third transistor responsive to a second control signal and an output of the voltage detection circuit for selectively coupling the controlling terminal of the first transistor and the charge storage element to a ground voltage. In some embodiments, the charge storage element comprises a metal-oxide-semiconductor capacitor.

In additional embodiments of the invention, the detection circuit comprises a current detection circuit. The current detection circuit may be configured to compare the measured current of the data line and a reference current and output a control signal based on whether the measured current is greater than or less than the reference current. Furthermore, the controller circuit may include a current mirror circuit configured to increase an amount of current supplied to the phase-change memory cell until the control signal output by the current detection circuit indicates that the measured current is less than the reference current and maintain the amount of current supplied to the phase-change memory cell when the control signal output by the current detection circuit indicates that the measured current is greater than the reference current.

Some embodiments of the invention provide phase-change memory write drive circuits that include a current detection circuit coupled to a data line of a phase-change memory and a current generation circuit responsive to a control signal and coupled to the data line of the phase-change memory. The current generation circuit is configured to supply current to the data line of the phase-change memory responsive to the control signal and to increase an amount of current supplied to the data line of the phase-change memory until the current detection circuit indicates that a current measured by the current detection circuit is greater than a reference current and maintain the amount of current supplied to the phase-change memory when the current measured by the current detection circuit indicates that the measured current is greater than the reference current.

Further embodiments of the invention provide phase-change memory write drive circuits that include a voltage detection circuit coupled to a data line of a phase-change memory and a current generation circuit responsive to a control signal and coupled to the data line of the phase-change memory. The current generation circuit is configured to supply current to the data line of the phase-change memory responsive to the control signal and to increase an amount of current supplied to the data line of the phase-change memory until the voltage detection circuit indicates that a voltage measured by the voltage detection circuit is less than a reference voltage and maintain the amount of current supplied to the phase-change memory when the voltage measured by the voltage detection circuit indicates that the measured voltage is less than the reference voltage.

Advantageous embodiments of the invention, as described in detail below, as well as the prior art embodiments discussed above to facilitate the understanding of the invention are shown in the drawings, in which:
**FIGs. 1A** and **1B** are illustrations of a phase-change memory cell.
**FIG. 2** is a schematic diagram of a phase-change memory cell.
**FIG. 3** is graph illustrating the change in state of a phase-change material as a function of time and temperature.
**FIG. 4** is a graph illustrating the current and voltage relationship for a phase-change material.
**FIG. 5A** is a schematic illustration of a conventional driver circuit and phase-change memory cells.
**FIG. 5B** is a graph of resistance versus voltage for a phase-change memory cell.
**FIG. 6** is a flowchart illustrating operations for driving a phase-change memory cell according to some embodiments of the present invention.
**FIG. 7** is a block diagram of a phase-change memory cell and driver circuit according to some embodiments of the present invention.
**FIG. 8** is a schematic illustration of a phase-change memory and driver circuit according to some embodiments of the present invention.
**FIGs. 9** and **10** are timing diagrams illustrating the operation of the circuit of **FIG. 8**.

The invention now will be described more fully hereinafter with reference to the accompanying drawings, in which embodiments of the invention are shown. However, this invention should not be construed as limited to the embodiments set forth herein. Rather, these embodiments are provided so that this disclosure will be thorough and complete, and will fully convey the scope of the invention to those skilled in the art. In the drawings, the thickness of layers and regions are exaggerated for clarity. Like numbers refer to like elements throughout. As used herein the term "and/or" includes any and all combinations of one or more of the associated listed items.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

It will be understood that when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

It will be understood that, although the terms first, second, etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the invention.

Furthermore, relative terms, such as "lower" or "bottom" and "upper" or "top," may be used herein to describe one element's relationship to another elements as illustrated in the Figures. It will be understood that relative terms are intended to encompass different orientations of the device in addition to the orientation depicted in the Figures. For example, if the device in the Figures is turned over, elements described as being on the "lower" side of other elements would then be oriented on "upper" sides of the other elements. The exemplary term "lower", can therefore, encompasses both an orientation of "lower" and "upper," depending of the particular orientation of the figure. Similarly, if the device in one of the figures is turned over, elements described as "below" or "beneath" other elements would then be oriented "above" the other elements. The exemplary terms "below" or "beneath" can, therefore, encompass both an orientation of above and below.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Some embodiments of the invention provide phase-change memories and/or methods of operating phase-change memories that control the amount of current supplied to a phase-change memory cell based on a detection of a change in resistance of the memory cell. Embodiments of the invention are described herein with reference to the change in resistance of the memory cell being detected based on a voltage change, however, the change in resistance could also be detected based on a current change. Accordingly, embodiments of the invention should not be construed as limited to the particular illustrative examples provided herein.

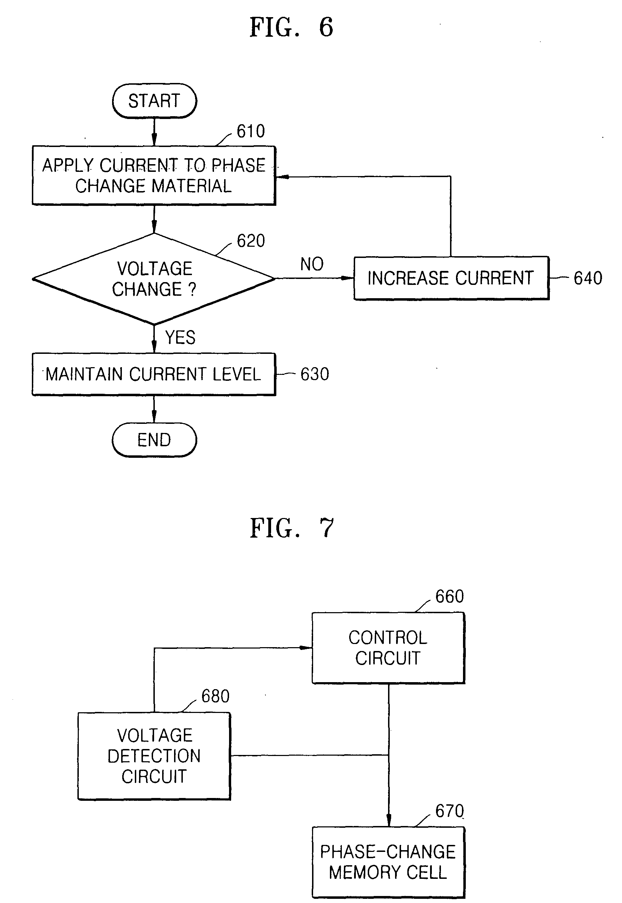

**FIG. 6** is a flowchart illustrating operations for programming a phase-change memory cell according to some embodiments of the invention. As seen in FIG. 6, a phase-change memory cell is programmed by applying current to the phase-change material at a first level (block **610**). The voltage across the phase-change material is monitored (block **620**) and if a change in the voltage is not detected (block **620**), the level of current supplied to the phase-change material is increased (blocks **640** ad **610**). When a change in voltage across the phase-change material is detected that indicates that the resistance level of the phase-change material has changed (block **620),** the current level supplied to the phase-change material is maintained at that level (block **630).** For example, the current may be increased to the phase-change material until the voltage corresponding to the current exceeds the threshold voltage and then the current is maintained at a constant level. Thus, despite the narrow set window, the current and voltage applied to the phase-change material may be maintained in a stable manner. In particular embodiments, the change in resistance of the phase-change material may be detected by measuring the voltage level of a data line of the phase-change memory. Such a control of the current may be provided on a bit line by bit line or cell by cell basis.

**FIG. 7** is a block diagram of a phase-change memory device according to some embodiments of the present invention. As seen in **FIG. 7,** the phase-change memory device includes a control circuit **660,** a phase-change memory cell **670** and a voltage detection circuit **680.** The voltage detection circuit **680** is configured to measure a voltage of a data line coupled to the phase-change memory cell. The control circuit **660** is coupled to the phase-change memory cell **670** and configured to control an amount of current supplied to the phase-change material of the phase-change memory cell **670** based on an output of the detection circuit **680**. The phase-change memory cell **670** may be a conventional phase-change memory cell as illustrated, for example, in **FIGs. 1A, 1B** and **2.**

The voltage detection circuit **680** is configured to compare the measured voltage of the data line and a reference voltage and output a control signal based on whether the measured voltage is greater than or less than the reference voltage. The controller circuit **660** may be provided by a current mirror circuit configured to increase an amount of current supplied to the phase-change memory cell until the control signal output by the voltage detection circuit **680** indicates that the measured voltage is less than the reference voltage and maintain the amount of current supplied to the phase-change memory cell **670** when the control signal output by the voltage detection circuit indicates that the measured voltage is less than the reference voltage. The reference voltage may be established based on the ratio of the set resistance to the reset resistance of the phase-change material. In some embodiments the ratio may be greater than 100.

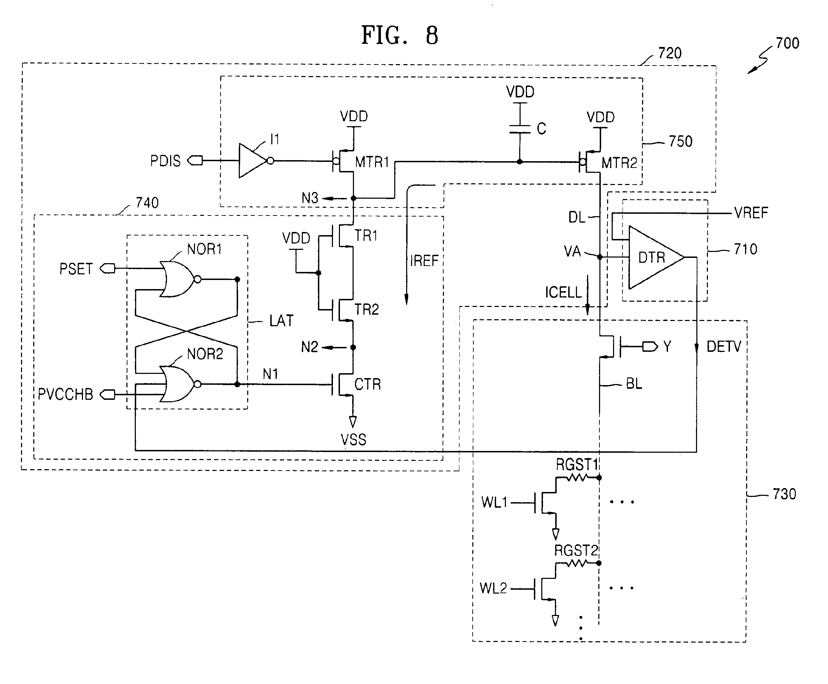

**FIG. 8** is a circuit diagram of a phase-change memory device **700** according to some embodiments of the present invention. As seen in **FIG. 8,** the phase-change memory device **700** includes a detection circuit **710**, a controller **720** and a memory array **730.** The detection circuit **710** may provide the detection circuit **680** of **FIG. 7,** the controller **720** may provide the controller circuit **660** of **FIG. 7** and the memory array **730** may provide the phase-change memory cell **670** of **FIG. 7,** in some embodiments.

As is further illustrated in **FIG. 7,** the controller **720** may include a current generator controller unit **740** and a current generator **750.** The current generator controller unit **740** and the current generator **750** may provide a current mirror circuit such that the current **ICELL** supplied to the memory array **730** by the current generator **750** is controlled by the current **IREF** in the current generator controller unit **740.** The current generator **750** is responsive to a first control signal **PDIS** that controls whether or not the current **ICELL** is supplied to the phase-change memory cell of the memory array **730** and charges capacitor **C** up to the VDD level before a set operation.

The memory array **730** may include a plurality of phase-change memory cells that are interconnected by bit lines and selected by word lines. For example, the bit line **BL** may be coupled to multiple phase-change memory cells that are individually controlled by access transistors coupled to word lines (**WL1, WL2,** ...) of the memory array **730.** Each memory cell may include a phase-change material and a respective phase change material is illustrated in **FIG. 7** as **RGST1, RGST2,** etc. Current supplied to the bit line passes through the phase-change material of phase-change memory cells for which the word line is active and may be controlled as described herein to program the state of the phase-change material of the phase-change memory cell.

The current generator controller unit **740** and the current generator **750** may receive three control signals. A first control signal **PDIS** controls whether the current generator **750** drives the memory array **730** and charges node **N3** up to the **VDD** level. A second control signal **PSET** provides a set pulse that is activated to place the phase-change material of a selected phase-change memory cell(s) into a set state. A third signal **PVCCHB** may be activated once during a power-up sequence and/or before every write operation of the semiconductor memory device **700** to provide an initialization of a flip-flop circuit LAT.

As is seen in **FIG. 8,** the controller **720** includes a first transistor **MTR2** having controlled terminals coupled between a data line (the bit line **BL**) of the phase-change memory cell and a supply voltage **VDD.** A charge storage element (the capacitor **C**) is coupled between a controlling terminal of the first transistor **MTR2** and the supply voltage **VDD** or the ground voltage **VSS.** A second transistor **MTR1** is responsive to the first control signal and selectively couples the controlling terminal of the first transistor **MTR2** to the supply voltage **VDD** to control the flow of current to the data line. A third transistor **CTR** is responsive to a second control signal **PSET** and an output **DETV** of the detection circuit **710** for selectively coupling the controlling terminal of the first transistor **MTR2** and the charge storage element **C** to a ground voltage **VSS**. The charge storage element **C** may be provided by a metal-oxide-semiconductor capacitor.

The current generator controller unit **740** includes a latch **LAT** that operates as a set/reset latch with the reset state overriding the set state. Thus, the NOR gates **NOR1** and **NOR2** are cross-coupled and have as a SET input the **PSET** signal and as reset inputs the **PVCCHB** signal and the feedback signal **DETV** output by the detection circuit **710**. The current generator controller unit **740** further includes a control transistor **CTR** having its controlling terminal coupled to the output of the set/reset latch **LAT** and which controls the current flow from the node **N3** through the transistors **TR1** and **TR2** which acts as an active resistor **R.** By using the charge storage element **C** and the active resistor **R,** the node voltage of **N3** can be decreased slowly from VDD to VSS with an RC time constant.

The detection circuit **710** is provided by a voltage comparator **DTR** that compares the voltage at the node **VA** with a reference voltage. Because the change in resistance between the SET state and the RESET state of the phase-change memory cells is large, the reference voltage level need only be set to a voltage between the voltage level for the phase-change memory cell when the memory cell is in a SET state and when it is in a RESET state. If the voltage at the node **VA** is greater than the reference voltage, the detection circuit **710** outputs the signal **DETV** as a low value and if the voltage at the node **VA** is less than the reference voltage, the detection circuit **710** outputs the signal **DETV** as a high value.

As is further illustrated in **FIG. 8,** the current from the current generator 750 may be selectively provided to the bit line through a pass transistor that may be controlled by an enable signal **Y.**

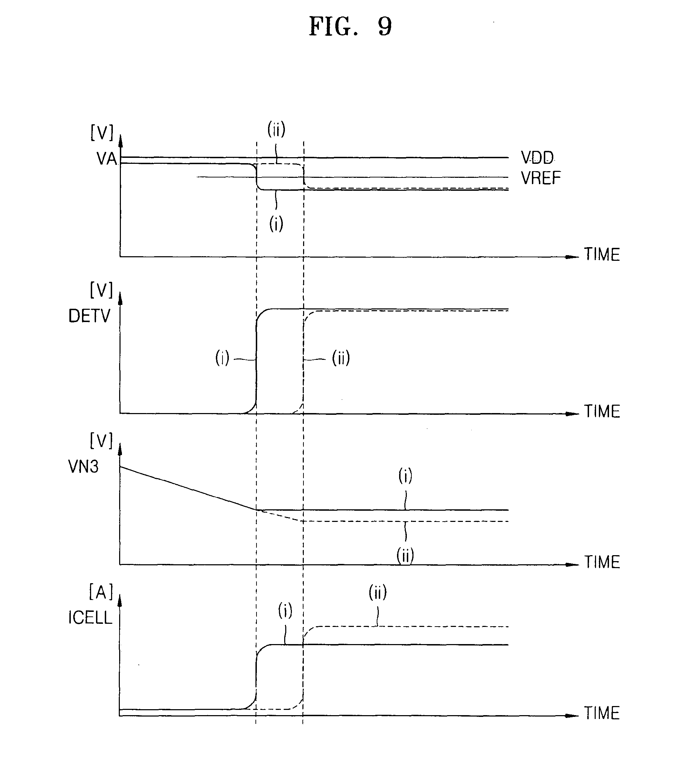

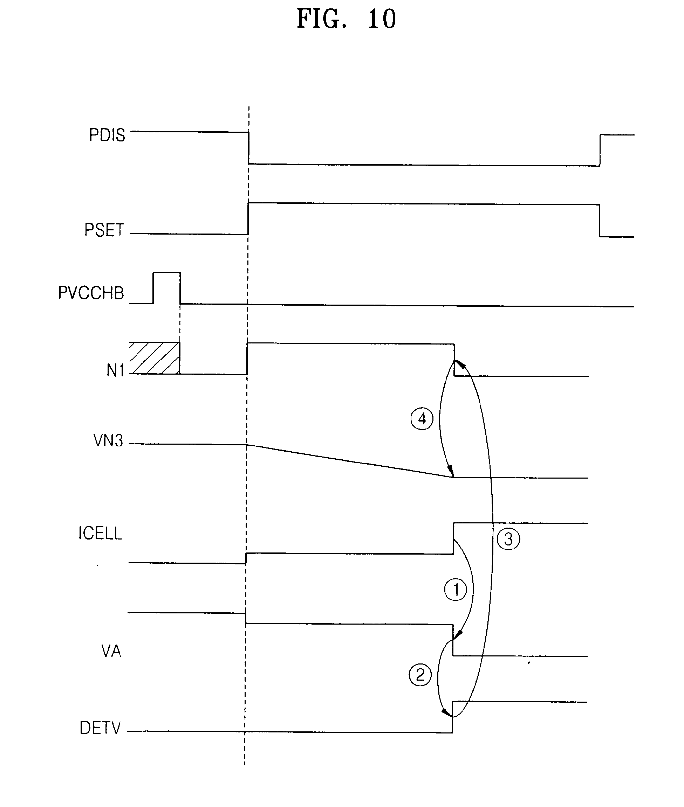

Operation of the phase-change memory device **700** will now be described in further detail with reference to **FIGs. 9** and **10.** At power on, the **PVCCHB** signal provides a reset pulse to set the output of the latch **LAT** to a known state. The **PSET** signal is low indicating that an operation to place the memory cell(s) in a SET state is not being performed. Thus, after the reset pulse of **PVCCHB** is received, the node **N1** is set to a low state and the transistor **CTR** is turned off. Furthermore, the control signal **PDIS** is high and so the output of the inverter **I1** is low and the nMOS transistor **MTR1** is turned on so that the capacitor **C** is precharged to **VDD** and the node **N3** is at **VDD** so that the transistor **MTR2** is off. Furthermore, a separate transistor could be provided to precharge the node **VA.** Such a transistor could precharge the node **VA** responsive to the control signal **PDIS** such that the node **VA** and the node **N3** were both charged to near **VDD.** The node **N3** and/or the node **VA** may be charged to near **VDD** responsive to a power on signal.

When the phase-change memory cell is to be programmed to a SET state, the control signal **PDIS** transitions to a low level and the control signal **PSET** transitions to a high level. When **PDIS** goes low and **PSET** goes high, the transistor **MTR1** is turned off and the set/reset latch **LAT** is set so that the node **N1** goes high and the transistor **CTR** turns on. Thus, the capacitor **C** begins to discharge through the transistors **TR1, TR2** and **CTR.** Accordingly, the voltage at the node **N3** decreases as illustrated by the signal **VN3** in **FIGs. 9** and **10.** As the voltage at the node **N3** decreases the transistor **MTR2** provides increased current **ICELL** to the phase memory cells. While the current **ICELL** is increased, the current **ICELL** is illustrated as a substantially flat line for **ICELL** in **FIGs. 9** and **10** during this period because of the scale of the drawing. Thus, as the voltage at node **N3 (VN3)** decreases, **ICELL** increases.

When the phase-change memory cell changes state such that the resistance of the phase-change material changes, the current **ICELL** increases and the voltage at the node **VA** decreases below the reference voltage **VREF.** Thus, the signal **DETV** transitions from low to high and the latch **LAT** is reset so that the node **N1** is at a low state and the transistor **CTR** turns off which floats the node **N3** and stops the decrease in the voltage **VN3** at the node **N3**. The duration for which **VN3** decreases is typically about 10 ns. Accordingly, the increase in current provided by the transistor **MTR2** is stopped and the current is maintained at substantially the same amount of current provided when the **DETV** signal turned off the transistor **CTR.** The current **ICELL** is maintained at this level until the signal **PDIS** transitions to a high level which turns on the transistor **MTR1** that pulls the node **N3** to nearly **VDD** and turns off the transistor **MTR2**. Thus, the duration of the current supplied to the memory cell may be controlled by the duration of the signal **PDIS.**

As seen in **FIG**. **9**, if the threshold voltage, Vth, differs between memory cells, the current level at which the voltage **VA** drops below the reference voltage will differ. However, because the level of current supplied is based on the detection of the voltage change at the node **VA,** the voltage **VN3** will continue to drop and the current **ICELL** will increase until the threshold voltage is reached. Accordingly, memory cells with different threshold voltages may be provided different levels of current based on the characteristics of the individual memory cells.

While embodiments of the invention have been described with reference to voltage detection of the voltage at the node **VA,** the detection circuit **710** could also be provided as a current detection circuit. Thus, the voltage comparator **DTR** could be replaced with a current sense amplifier and the current **ICELL** could be monitored to detect that it has exceeded a reference current level to generate the control signal **DETV**. Accordingly, embodiments of the present invention should not be construed as limited to voltage detection techniques but may utilize any technique for detecting the change in resistance of the phase-change memory cell and maintaining the current supplied to the cell at a constant level after detection of the change in resistance.

Embodiments of the invention could also be utilized in combination with other phase-change memory programming techniques, such as, for example, in combination with the phase-change memories that control pulse duration based on a detected state of the memory that are described in United States Patent Publication No. 2004/0246804 and published December 9, 2004, the disclosure of which is incorporated herein by reference as if set forth in its entirety.

While the invention has been particularly shown and described with reference to exemplary embodiments thereof, it will be understood by those of ordinary skill in the art that various changes in form and details may be made therein without departing from the spirit and scope of the invention as defined by the following claims.

## Claims

1. A method of programming a phase-change memory device,
**characterized by**
controlling an amount of current supplied to a phase-change material of the phase-change memory device based on a measure of resistance of the phase-change material during programming of the phase-change memory device.

2. The method of Claim 1, wherein controlling an amount of current comprises:
measuring a voltage across the phase-change material or a current supplied to the phase-change material of the phase-change memory device; and
controlling an amount of current supplied to the phase-change material of the phase-change memory device based on the measured voltage across the phase-change material or current supplied to the phase-change material.

3. The method of Claim 2, wherein controlling an amount of current comprises:
increasing the amount of current supplied to the phase-change material until the measured voltage or current level changes with respect to a reference voltage or current value; and
maintaining the current constant if the measured voltage or current level has changed with respect to the reference voltage or current value.

4. The method of Claim 3, wherein the change of the measured voltage level with respect to the reference voltage comprises the measured voltage level falling below the reference voltage value or wherein the change of the measured current with respect to the reference current comprises the measured current exceeding the reference current value.

5. The method of Claim 3 or 4, wherein increasing the amount of current supplied to the phase-change material until the measured voltage level changes with respect to a reference voltage value comprises increasing the amount of a reference current supplied to a current mirror circuit so as to increase an amount of current supplied to the phase-change material until the measured voltage level changes with respect to a reference voltage value controlling an amount of current supplied.

6. The method of Claim 5, further comprising precharging a node of the current mirror that controls the current supplied to the phase-change material.

7. The method of Claim 6, wherein precharging the node is responsive to a power on signal.

8. The method of any of Claims 2 to 7, further comprising precharging a node where the voltage across the phase-change material is detected.

9. The method of Claim 8, wherein the node that is precharged comprises a data line of the phase-change memory device.

10. The method of any of Claims 3 to 9, wherein current supplied to the phase-change material is supplied by a current mirror circuit and wherein maintaining the current constant comprises floating a node of the current mirror that controls the current supplied to the phase-change material when the measured voltage falls below reference voltage.

11. A phase-change memory device, comprising:
a phase-change memory cell (670) comprising a phase-change material;
**characterized by**
means (660, 680) for controlling an amount of current supplied to the phase-change material of the phase-change memory cell based on a measure of resistance of the phase-change material during programming of the phase-change memory cell or based on a measure of a voltage and/or current of a data line coupled to the phase-change memory cell.

12. The phase-change memory device of Claim 11, wherein the means for controlling a current comprises:
means for measuring a voltage across the phase-change material of the phase-change memory device or means for measuring a current supplied to the phase-change material of the phase-change material; and
means for controlling an amount of current supplied to the phase-change material of the phase-change memory device based on the measured voltage across the phase-change material or the measured current supplied to the phase-change material.

13. The phase-change memory device of Claim 12, wherein the means for controlling an amount of current supplied comprises:
means for increasing the amount of current supplied to the phase-change material until the measured voltage or current level changes with respect to a reference voltage or current value; and
means for maintaining the amount of current constant if the measured voltage or current level has changed with respect to the reference voltage or current value.

14. The phase-change memory device of Claim 13, wherein the amount of constant current is substantially the same as the amount to which the current was increased prior to the change in measured voltage.

15. The phase-change memory device of Claim 13 or 14, wherein the change of the measured current with respect to the reference current comprises the measured current exceeding the reference current value.

16. The phase-change memory device of any of Claims 11 to 15, wherein the controlling means comprises a detection circuit configured to measure of a voltage and/or current of a data line coupled to the phase-change memory cell; and a controller circuit coupled to the phase-change memory cell and configured to control an amount of current supplied to the phase-change material of the phase-change memory cell based on an output of the detection circuit.

17. The phase-change memory device of Claim 16, wherein the detection circuit comprises a voltage detection circuit configured to compare the measured voltage of the data line and a reference voltage and output a control signal based on whether the measured voltage is greater than or less than the reference voltage.

18. The phase-change memory device of Claim 21, wherein the detection circuit comprises a current detection circuit configured to compare the measured current of the data line and a reference current and output a control signal based on whether the measured current is greater than or less than the reference current.

19. The phase-change memory device of any of Claims 16 to 18, wherein the controller circuit comprises a current mirror circuit configured to increase an amount of current supplied to the phase-change memory cell until the control signal output by the voltage detection circuit or current detection circuit indicates that the measured voltage is less than the reference voltage or the measured current is greater than the reference current and maintain the amount of current supplied to the phase-change memory cell when the control signal output by the voltage detection circuit or the current detection circuit indicates that the measured voltage is less than the reference voltage or the measured current is greater than the reference current.

20. The phase-change memory device of Claim 19, where the current mirror circuit is further responsive to a first control signal to control whether or not current is supplied to the phase-change memory cell.

21. The phase-change memory device of Claim 19 or 20, wherein the current mirror circuit comprises:
a first transistor having controlled terminals coupled between a data line of the phase-change memory cell and a supply voltage;
a charge storage element coupled between a controlling terminal of the first transistor and the supply voltage;
a second transistor responsive to the first control signal that selectively couples the controlling terminal of the first transistor to the supply voltage; and
a third transistor responsive to a second control signal and an output of the voltage detection circuit for selectively coupling the controlling terminal of the first transistor and the charge storage element to a ground voltage.

22. The phase-change memory device of Claim 21, wherein the charge storage element comprises a metal-oxide-semiconductor capacitor.

23. A phase-change memory write drive circuit, comprising:
a current detection circuit or a voltage detection circuit (680) coupled to a data line of a phase-change memory;
a current generation circuit (750) responsive to a control signal and coupled to the data line of the phase-change memory and configured to supply current to the data line of the phase-change memory responsive to the control signal and to increase an amount of current supplied to the data line of the phase-change memory until the current or voltage detection circuit indicates that a current measured by the current detection circuit is greater than a reference current or a voltage measured by the voltage detection circuit is less than a reference voltage and maintain the amount of current supplied to the phase-change memory when the current or voltage measured by the current or voltage detection circuit indicates that the measured current is greater than the reference current or the measured voltage is less than the reference voltage.
